(19) Europäisches Patentamt
European Patent Office
Office européen des brevets

(11) **EP 3 730 961 A1**

(12) **EUROPEAN PATENT APPLICATION**

(43) Date of publication:
**28.10.2020 Bulletin 2020/44**

(51) Int Cl.:
***G01R 33/56*** *(2006.01)*   ***G01R 33/561*** *(2006.01)*

(21) Application number: **19171216.5**

(22) Date of filing: **25.04.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Koninklijke Philips N.V.**
**5656 AG Eindhoven (NL)**

(72) Inventors:
• **DONEVA, Mariya Ivanova**
**5656 AE Eindhoven (NL)**
• **NAGTEGAAL, Martijn**
**5656 AE Eindhoven (NL)**

(74) Representative: **de Haan, Poul Erik et al**
**Philips International B.V.**
**Philips Intellectual Property & Standards**
**High Tech Campus 5**
**5656 AE Eindhoven (NL)**

(54) **A METHOD FOR MULTI-COMPONENT ANALYSIS ON MRI MEASUREMENT DATA**

(57)     It is an object of present invention to provide for a faster method of multi-component analysis. This object is achieved by a method for multi-component analysis on MRI measurement data, wherein a component is defined by one or more tissue component parameters among which preferably one is a T2 or T1 value. The method comprising steps of
- receiving the MRI measurement data, wherein the MRI measurement data comprises multiple signals corresponding to multiple voxels in an MRI image and wherein the MRI measurement data is acquired by means of a sequence encoding the one or more tissue component parameters;

- identifying components in the multiple voxels by minimizing a difference between the multiple signals and a linear combination of weighted simulated temporal signal evolutions, wherein different simulated temporal signal evolutions represent different components and are based on different values of the one or more tissue component parameters, and wherein the identification of the components is performed under the assumption that the possible components are the same for all of the multiple voxels and wherein a higher total number of components is penalized over a lower total number of components, and wherein the simulated temporal signal evolutions are weighted by a weight factor that is non-negative.

Fig. 4

402

EP 3 730 961 A1

**Description**

FIELD OF THE INVENTION

The invention relates to the field of magnetic resonance imaging and more specifically to multi-component analysis of magnetic resonance imaging data.

BACKGROUND OF THE INVENTION

Magnetic resonance fingerprinting (MRF) is a technique for simultaneous mapping of multiple quantitative parameters. MRF has been mainly applied for single-component matching of a set of system and tissue parameters, e.g. T1,T2 and B1, to each voxel. The standard method matches the measured signal to a pre-calculated dictionary with a pattern recognition algorithm based on the inner product similarity measure. However, single-component matching only considers the average signal produced by multiple tissues in a voxel. Multiple tissues can be present in a voxel either in the boundary region between two tissues or simply as a mixture of multiple components because of the complex structure of tissue.

In the brain, the first effect occurs in the boundary region between white and grey matter, the second example is the case for myelin in the white matter. This effect can lead to blurring artefacts or averaged tissue parameters in the parameter maps obtained by a single component matching.

Similar effects occur in other anatomies of interest as well. For example within the prostate, epithelium, lumen and stroma can occur in a single voxel, because in general a voxel size is very large compared to the organization of a tissue on a cellular level.

Multi-component analysis takes into account that the voxel can consist of several tissues and assumes that the measured signal is composed of a weighted sum of signals corresponding to the individual tissues present in the voxel. Multi-component analysis is not limited to MRF, but can be performed for other types of sequences as well. For example standard relaxometry scans like multi-echo spin echo (MESE) T2 mapping by performing a multi-exponential fit.

Whittall KP, MacKay AL. Quantitative Interpretation of NMR Relaxation Data. Journal of Magnetic Resonance (1969) 1989 Aug;84(1):134-152 introduced the T2 non-negative least squares (T2NNLS) algorithm, which is now the standard method for multi-component analysis, for multi echo spin echo. With this algorithm a smooth T2 spectrum is obtained and the myelin water fraction (MWF) is determined by integrating over all weights in the spectrum with typically around T2 < 40 ms, however this may vary for systems and patients. Besides myelin water, another peak can be recognised which belongs to intra-extra cellular water.

The methods used to obtain a MWF from multi-echo spin echo measurements including correction for flip angle inhomogeneities report computation times of above half an hour for a single slice and include spatial smoothing of the results to make the problem more robust to noise. A drawback of this smoothening might be that small pathologies are smoothed out by the reconstruction.

Multi-component analysis applied to MRF has the potential to distinguish more tissues than multi-exponential methods, because multiple tissue parameters are taken into account. The practical application is however limited by long computation times reported to be 1-10s per voxel.

SUMMARY OF THE INVENTION

It is an object of present invention to provide for a faster method of multi-component analysis and/or to provide for a method for which the results are more robust and / or easier to interpret. This object is achieved by a method according to claim 1, a computer program product according to claim 12 or a magnetic resonance imaging system according to claim 13.

It is an insight of the inventors that existing methods for MRF multi-component analysis either use fixed components or perform the analysis separately for each voxel and that this may make it difficult to interpret the results over a larger region of interest.

Instead of performing multi-component analysis for each voxel individually, embodiments of the invention propose to consider all voxels together. The main premise of the proposed approach is that the temporal magnetic resonance signal evolution (temporal signal evolutions in short) can be represented as a linear combination of a few basis signals, corresponding to different components (e.g. myelin water, intra- and extra-cellular water, free water, epithelium, lumen and stroma). These components can be described by one tissue component parameter or by a combination of multiple tissue component parameters. These tissue component parameters could for example be T1, T2,, apparent diffusion coefficient etc.

The underlying assumption of the method according to embodiments of the invention is that the possible components are the same for all voxels in the scan or region of interest. This implies that for the entire region of interest a certain tissue type is assumed to have the same tissue component parameters, e.g. the same combination of T1 and T2 values.

The above leads to a very important constraint used in the method for multi-component analysis according to embodiments of the invention, namely the joint sparsity constraint. Because, it is assumed that the temporal signal evolutions can be represented by a few basis signals it can be assumed that the solution to the multi-component problem is sparse, meaning in this case that only a limited number of components exist and that if the problem is represented by a linear inverse problem there are only very few non-zero entries.

Because it is further assumed that the total (low) number of components is the same for all voxels of interest, it is assumed that the sparstiy is very similar for all the voxels of interest, meaning that joint sparsity is assumed. The proposed method therefore penalizes a higher total number of components over a lower total number of components.

Besides this joint-sparsity constraint, embodiments of the invention include a common non-negativity constraint for the components, meaning that the components cannot have a negative or complex weight in a voxel, i.e. a negative presence. These two constraints may result in a faster method of multi-component analysis and / or more robust method and / or results that may be more easy to interpret.

The use of the joint-sparsity and common non-negativity constraint will often result in a small (around 7) number of components starting from a dictionary of more than 3000 components. This may make the results more easy to interpret, while the computation time may be less than a minute for a single slice on a simple laptop. The method is applicable to different sequences including MRF, multi echo spin echo, inversion recovery, etc.

According to further embodiments of the invention, the method further comprises the steps of receiving a B1 map for the multiple voxels and taking into account a B1 value for the respective voxels when identifying the components. This embodiment is advantageous, because while it may be logical to assume that the components present are the same over an entire region of interest and hence there is a limited variation in tissue component parameters over the region of interest, there may be a perceived variation in tissue component parameters caused by measurement inaccuracies. One common factor introducing inaccuracies in the measured tissue component parameters is an inhomogeneous B1 field. By taken into account such inhomogeneities, they can be corrected for.

The B1 map can be measured or be part of the simulation. A separate measurement of the B1 map may be advantageous, because it has the potential to be faster.

A (large) set of simulated temporal signal evolutions may be created for a (large) number of parameter values, like T1, T2, B1, etc. This set of simulated temporal signal evolutions is in the field of MRF also known as a dictionary. After the B1 value for a specific voxel has been determined, a selection of the set of simulated temporal signal evolutions (sub-dictionary) is being used for the determination of the components in the specific voxel. Only the simulated temporal signal evolutions are being used that correspond to the B 1 value determined. The method still steers towards a limited number of components and therefore to a limited number of tissue component parameter (combinations), but now the method takes into account the extent to which the real value of the tissue component parameter is affected by the inhomogeneities in the B1 field. In this way, efficient use can be made of B1 information available.These and other aspects of the invention will be apparent from and elucidated with reference to the embodiments described hereinafter.

BRIEF DESCRIPTION OF THE FIGURES

Fig.1 diagrammatically shows a method according to embodiments of the invention and
Fig.2 displays the flip angle variation in a possible sequence and
Fig.3 displays the results of the multi-component analysis on the phantom data and
Fig.4 displays the estimated component weights in in-vivo data and
Fig.5 diagrammatically displays a magnetic resonance imaging system according to the invention.

DETAILED DESCRIPTION OF THE INVENTION

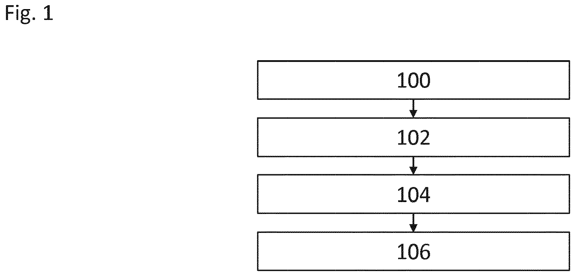

Fig.1 diagrammatically shows a method according to embodiments of the invention. First, temporal signal evolutions are being simulated 100, wherein different simulated temporal signal evolutions represent different components and are based on different values of the one or more tissue component parameters. Depending on the tissue component parametrs of interest (e.g. T1, T2, etc) and the expected values of the tissue component parameters, the temporal signal evolutions are simulated. The creation of the set of simulated temporal signal evolutions does not necessarily need to be repeated for each patient. Therefore, this creation could also be performed at a different location and / or by different means from where and by which the multi-component analysis is being performed. Preferably, temporal signal evolutions are being simulated for a variety of B1 values.

Then, in step 102, a B1 map is received. This B1 map provides B1 values related to the voxels of interest for the following multi-component analysis. The B1 map preferably is created from B1 measurement data acquired by an MRI system. After that, MRI measurement data is received 102. The MRI measurement data comprises multiple signals corresponding to multiple voxels in an MRI image. The MRI measurement data is acquired by means of a sequence encoding the one or more tissue component parameters. This sequence could for example be a multi-echo spin-echo acquisition in case T2 would be a tissue component parameter of interest. Another option is inversion recovery multi echo spin echo, as described in Kim D, Wisnowski JL, Nguyen CT, Haldar JP. Relaxation-Relaxation Correlation Spectroscopic Imaging (RR-CSI): Leveraging the Blessings of Dimensionality to Map In Vivo Microstructure. arXiv:180605752 [eess] 2018 Jun Also the sequence could be an MR fingerprinting sequence. It the latter case there are multiple tissue component parameters that can be encoded within a single sequence. Then in step 106 components are identified in multiple voxels simultaneously. This is achieved by minimizing a difference between the multiple signals and a linear combination of weighted simulated temporal signal evolutions. Different simulated temporal signal evolutions represent different components and are based on different values of the one or more tissue component parameters. The identification of the components is performed under the assumption that the possible components are the same for all of the multiple voxels. A higher total number of components is penalized over a lower total number of components. The simulated temporal signal evolutions are weighted by a weight factor that is non-negative.

Below more information about the background of the method and preferred implementations will be provided.

In a multi-component signal model, the temporal signal evolution $x_j$ of a voxel $j$, can be written as

$$x_j = Dc_j + e_j \qquad (1)$$

where $D$ is a set of simulated temporal signal evolutions, which in MRF is often called a dictionary, $c_j$ is a vector containing the weights for the different components and $e_j$ is a noise term. The measured temporal signal evolutions are generally complex, however, when the phase of the signal is determined, the signal can be rotated to the real axis resulting in a real vector $x_j \in \mathbb{R}^{M*N}$ of length $M$, where $M$ is the number of time points of the (fingerprinting) sequence or the length of the signal after singular value decomposition (SVD) compression. $D \in \mathbb{R}^{M*N}$ contains the signal evolutions for $N$ different components. The measured temporal signal evolution is modelled as a non-negative linear combination of the simulated signal evolutions or dictionary signals. The weights of these different components are contained

in the vector $c_j \in \mathbb{R}^M_{\geq 0}$ Besides the non-negativity constraint, it can be assumed that the weight vector $c_j$ is sparse, thus the measured signal can be represented by a small number of components, representing a small number of tissue types. The weights for each component in Eq. (1) can for example be obtained by least squares minimisation. When the requirement is included that c is non-negative, the following non-negative least squares (NNLS) problem for each voxel $j$ is obtained:

$$\min_{c_j \in \mathbb{R}^N} \| x_j - Dc_j \|_2^2 \qquad (2)$$

For a set of simulated temporal signal evolutions with a large number of components, this problem is highly under-determined and has infinitely many solutions. This formulation is similar to a compressed sensing problem. Therefore, if the solution vector is sparse, there are some theoretical guarantees that it can be recovered using a sparsity constraint. However, due to the high coherence of simulated temporal signal evolutions, a unique solution only exists for very sparse solutions. One sparsity promoting approach to solve this problem is the active set NNLS algorithm as proposed by Lawson CL, Hanson RJ. Solving Least Squares Problems. SIAM; 1974, Chapter 23. The NNLS algorithm aims at finding a non-negative least squares solution.

Another approach to restrict the solution would be by means of a joint sparsity constraint. This could for example be implemented in the form of regularisation. This could for example be achieved by means of the following equation:

$$\min_{c_j \in \mathbb{R}^N} \| x_j - Dc_j \|_2^2 + \lambda^2 \| c_j \|_1^2 \qquad (2)$$

Where $\lambda > 0$ is the regularisation parameter.

The joint sparsity constraint may be introduced by using the weights $w_i = \|C[i,:]\|_2 + \epsilon$ (here $\epsilon = 10^{-4}$)($i=1,...,N$) to couple the different voxels.

There are multiple implementations foreseeable how the skilled person may exploit joint sparsity and non-negativity to arrive at a faster method for multi-component analysis. The invention is not limited to the specific examples mentioned in the description.

Other examples of how joint sparsity can be exploited are known from literature. Some examples of papers on the use of joint sparsity are provided below.

Duarte MF, Sarvotham S, Baron D,Wakin MB, Baraniuk RG. Distributed Compressed Sensing of Jointly Sparse Signals. In: Proceedings of the 2005 Asilomar Conference on Signals, Systems, and Computers IEEE; 2005. p. 1537-1541. In this paper all the algorithms proposed are greedy and try to minimize the $\ell_0$ norm

Cotter SF, Rao BD, Kjersti Engan, Kreutz-Delgado K. Sparse Solutions to Linear Inverse Problems with Multiple Measurement Vectors. IEEE Transactions on Signal Processing 2005 Jul;53(7):2477-2488. This paper refers to multiple measurements vector, meaning measurements with multiple sensors that are correlated and deals with enforcing the sparsity using the $\ell_p$ norm where $p \leq 1$. This is a very common expression in sparsity enforcing algorithms, not only joint sparsity.

Tropp JA, Gilbert AC, Strauss MJ. Algorithms for Simultaneous Sparse Approximation. Part I: Greedy Pursuit. Signal Processing 2006 Mar;86(3):572-588.

Tropp JA. Algorithms for Simultaneous Sparse Approximation. Part II: Convex Relaxation. Signal Processing 2006 Mar;86(3):589-602. Both the papers from Tropp et al. call the joint sparsity problem "simultaneous sparse approximation" and propose a greedy pursuit algorithm, which is a very different approach.

Blanchard JD, Cermak M, Hanle D, Jing Y. Greedy Algorithms for Joint Sparse Recovery. IEEE Transactions on Signal Processing 2014 Apr;62(7): 1694-1704 focuses on the use of greedy algorithms.

Further acceleration of the algorithm may be obtained by using SVD compression of the dictionary and temporal signal evolutions. Also pruning of the dictionary after the second iteration may accelerate the method. In the pruning all the unused dictionary components ($\|C[i,:]\|=0$) are removed, making the other iterations very fast. After 10 iterations the results become stable in general.

If B1 information is available for the voxels of interest, this information will be used for correcting the simulated temporal signal evolutions or the multiple measured signals 104. For example, based on a voxel's B1 value, only the part of the set of simulated temporal signal evolutions (sub-dictionary in MRF) that corresponds to this specific B1 value can be selected for use in the identification of the components. When taking into account B1 values, still it is assumed that there is only a limited number of components in the region of interest and hence only a limited number of tissue component parameter (combinations).

To test the proposed method, simulations were performed with a numerical phantom containing three different components. The relaxation times for the simulated components were chosen according to a three tissue brain model, where the measured MR signal is a combination of myelin water, intra- and extracellular water, and free water. The first component is in the range of myelin water (MW) with relaxation times (T1 = 67 ms and T2 = 13 ms), the second component in the range intra- and extracellular water (IEW) (T1 = 1000 ms and T2 = 100 ms) and the third component in the range of free water (FW) (T1 = 2000 ms and T2 = 500 ms).

Ten multi-component compositions were simulated, the first component had a weight of 10%in each composition, the other two components vary from 0%to 90%. Based on each of the ten multi-component mixtures the signal evolution was calculated, to each of these signals different independent Gaussian noise was added, resulting in a total of 10 x 10 simulated voxels with a signal to noise ratio of 50.

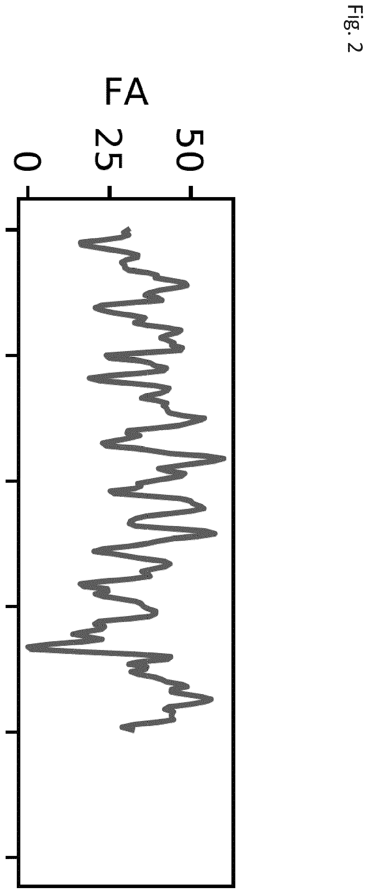

An MRF-FISP sequence was used according to Jiang Y, Ma D, Seiberlich N, Gulani V, Griswold MA. MR Fingerprinting Using Fast Imaging with Steady State Precession (FISP) with Spiral Readout: MRFingerprinting with FISP. Magnetic Resonance in Medicine 2015 Dec;74(6): 1621-1631. The MRF-FISP sequence of 200 time points was used for the simulations. Figure 2 displays the flip angle variation in the sequence used and a constant repetition time of TR = 15 ms. A logarithmically spaced dictionary containing 80 T1 values from 10 ms to 5 s and 80 T2 values from 10 ms to 5 s was computed with the extended phase graphs algorithm (EPG), with the restriction T2 $\leq$ T1 resulting in 3240 dictionary atoms.

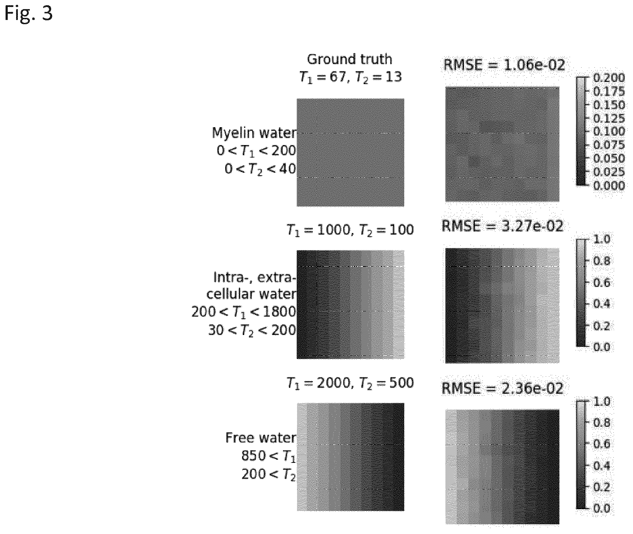

Fig.3 displays the results of the multi-component analysis on the phantom data. On the left column the ground truth is being displayed. On the right side the results achieved with a method according to the invention are displayed. The root mean squared error (RMSE) is considered to be low.

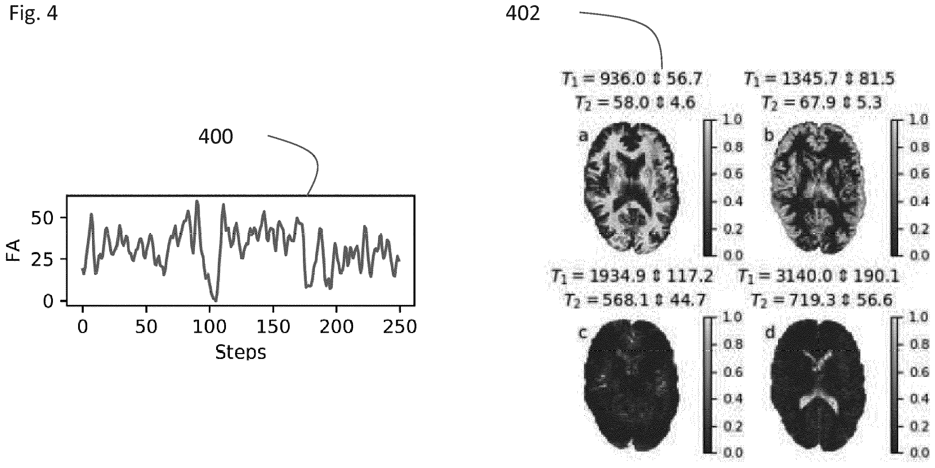

Further, ten 3T measurements on healthy volunteers were performed to test a method according to embodiments of the invention. The 10 volunteers were scanned on a 3.0 T Philips Achieva scanner with Sequence 2 as given in Fig. 4, 400 with a Cartesian sampling pattern, a FOV of 240 x 240 mm$^2$, in plane resolution of 1.25 x 1.25 mm$^2$, and 10 mm slice thickness. The acquisition time for one slice was 337 s. The dictionary included different relative B1-inhomogeneity values, ranging from 0.75 to 1.26 with step size 0.03, leading to a dictionary size of 845580.

The average values calculated for white matter over the 10 volunteers was T1 = 898.1 ms and T2 = 53.2 ms for white matter and T1 = 1241.0 ms and T2 = 58.8 ms for grey matter. Only four components were matched by the method in the 3T measurements brain measurements. Figure 4 displays the estimated component weights in in-vivo data 402 achieved with the flip angle variation displayed in 400. Component a and b are assumed to be related to white and grey matter respectively, the other two components are related to CSF or free water.

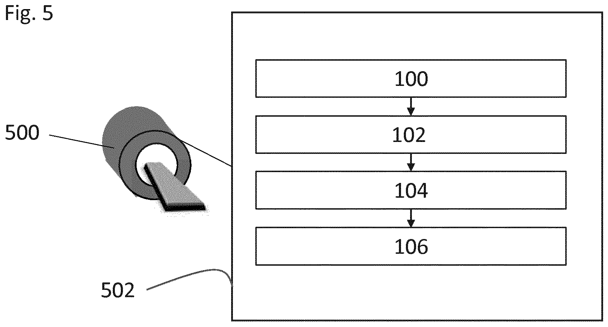

Fig.5 diagrammatically displays a magnetic resonance imaging system 500 according to the invention. The method could be performed by a computer program product 502. This computer program product could in turn be comprised in a magnetic resonance imaging system. This magnetic resonance imaging system could be further configured to acquire the MRI measurement data and / or the B1 map. The multi-component analysis could become part of the standard image reconstructions performed by the MRI system. The MRI system could further comprise a display configured for displaying the results of the multi-component analysis to a user.

The multi-component analysis could also be performed on a separate workstation or in the cloud or any other means known to the person skilled in the art.

Whilst the invention has been illustrated and described in detail in the drawings and foregoing description, such illustrations and description are to be considered illustrative or exemplary and not restrictive; the invention is not limited to the disclosed embodiments.

## Claims

1.  A method for multi-component analysis on MRI measurement data, wherein a component is defined by one or more tissue component parameters among which preferably one is a T2 or T1 value, the method comprising steps of

    - receiving the MRI measurement data, wherein the MRI measurement data comprises multiple signals corresponding to multiple voxels in an MRI image and wherein the MRI measurement data is acquired by means of a sequence encoding the one or more tissue component parameters;
    - identifying components in the multiple voxels by minimizing a difference between the multiple signals and a linear combination of weighted simulated temporal signal evolutions, wherein different simulated temporal signal evolutions represent different components and are based on different values of the one or more tissue component parameters, and wherein the identification of the components is performed under the assumption that the possible components are the same for all of the multiple voxels and wherein a higher total number of components is penalized over a lower total number of components, and wherein the simulated temporal signal evolutions are weighted by a weight factor that is non-negative.

2.  A method according to claim 1, further comprising the step of creating a set comprising the simulated temporal signal evolutions.

3.  A method according to claim 1, wherein the MRI measurement data is acquired by means of a multi-echo spin-echo acquisition.

4.  A method according to claim 1, wherein the MRI measurement data is acquired by means of an MR fingerprinting sequence.

5.  A method according to any of the previous claims, wherein the components are one or more of the following: myelin water, intra- and extra-cellular water, free water.

6.  A method according to any of the previous claims, wherein the MRI measurement data is acquired with a sequence encoding for diffusion and wherein different components are identified at least partly based on diffusion values.

7.  A method according to any of previous claims, wherein the components are either one or more of epithelium, lumen and stroma.

8.  A method according to any of the previous claims, further comprising the step of receiving a B1 map for the multiple voxels and taking into account a B1 value for the respective voxels when identifying the components.

9.  A method according to claim 8, wherein the method further comprises the steps of

    - creating a set of simulated temporal signal evolutions for a range of B1 values and;
    - determining a B1 value for a voxel and;
    - based on the voxel's B1 value, selecting a part of the set of simulated temporal signal evolutions for use in the identification of the components.

**10.** A method according to claim 8, wherein the B1 map originates from a B1 measurement.

**11.** A method according to claim 1 to 7, wherein B1 values are estimated from the MRI measurement data.

**12.** A computer program comprising program code means for performing the method according to any of claims 1-11.

**13.** A magnetic resonance imaging system comprising the computer program according to claim 12.

| | |
|---|---|
| 100 | |

↑

| | |
|---|---|
| 102 | |

↑

| | |
|---|---|
| 104 | |

↑

| | |
|---|---|
| 106 | |

Fig. 1

Fig. 2

Fig. 3

Ground truth
$T_1 = 67, T_2 = 13$

Myelin water
$0 < T_1 < 200$
$0 < T_2 < 40$

RMSE = 1.06e-02

0.200
0.175
0.150
0.125
0.100
0.075
0.050
0.025
0.000

$T_1 = 1000, T_2 = 100$

Intra-, extra-
cellular water
$200 < T_1 < 1800$
$30 < T_2 < 200$

RMSE = 3.27e-02

1.0
0.8
0.6
0.4
0.2
0.0

$T_1 = 2000, T_2 = 500$

Free water
$850 < T_1$
$200 < T_2$

RMSE = 2.36e-02

1.0
0.8
0.6
0.4
0.2
0.0

Fig. 4

Fig. 5

**EUROPEAN SEARCH REPORT**

Europäisches
Patentamt
European
Patent Office
Office européen
des brevets

Application Number

EP 19 17 1216

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SUNLI TANG ET AL: "Multicompartment Magnetic Resonance Fingerprinting", ARXIV.ORG, CORNELL UNIVERSITY LIBRARY, 201 OLIN LIBRARY CORNELL UNIVERSITY ITHACA, NY 14853, 28 February 2018 (2018-02-28), XP081213742, DOI: 10.1088/1361-6420/AAD1C3 | 1,2,4-7, 11-13 | INV. G01R33/56 G01R33/561 |
| Y | * page 6 - page 8 * | 8-10 | |
| X | KIM DAEUN ET AL: "Greedy algorithms for nonnegativity-constrained simultaneous sparse recovery", SIGNAL PROCESSING, ELSEVIER SCIENCE PUBLISHERS B.V. AMSTERDAM, NL, vol. 125, 6 February 2016 (2016-02-06), pages 274-289, XP029468750, ISSN: 0165-1684, DOI: 10.1016/J.SIGPRO.2016.01.021 * page 275 - page 279 * * page 283 - page 285 * | 1-3,6, 12,13 | |
| X | ROBERTO DUARTE ET AL: "Greedy Approximate Projection for Magnetic Resonance Fingerprinting with Partial Volumes", ARXIV.ORG, CORNELL UNIVERSITY LIBRARY, 201 OLIN LIBRARY CORNELL UNIVERSITY ITHACA, NY 14853, 18 July 2018 (2018-07-18), XP081426644, | 1,2,4-7, 11-13 | TECHNICAL FIELDS SEARCHED (IPC) G01R |
| Y | * page 2 - page 3 * * page 10 - page 12 * | 8-10 | |
| Y | WO 2018/178343 A1 (KONINKLIJKE PHILIPS NV [NL]) 4 October 2018 (2018-10-04) * page 7, line 20 - page 8, line 13 * | 8-10 | |

-/--

The present search report has been drawn up for all claims

| Place of search | Date of completion of the search | Examiner |
|---|---|---|
| Munich | 4 November 2019 | Durst, Markus |

page 1 of 2

Europäisches
Patentamt

European
Patent Office

Office européen
des brevets

**EUROPEAN SEARCH REPORT**

Application Number

EP 19 17 1216

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DAEUN KIM ET AL: "Relaxation-Relaxation Correlation Spectroscopic Imaging (RR-CSI): Leveraging the Blessings of Dimensionality to Map In Vivo Microstructure", ARXIV.ORG, CORNELL UNIVERSITY LIBRARY, 201 OLIN LIBRARY CORNELL UNIVERSITY ITHACA, NY 14853, 15 June 2018 (2018-06-15), XP081076301, * page 11 - page 13 * ----- | 1-13 | |
| T | MARTIJN NAGTEGAAL ET AL: "Fast multi-component analysis using a joint sparsity constraint for MR fingerprinting", MAGNETIC RESONANCE IN MEDICINE., 16 August 2019 (2019-08-16), XP055636033, US ISSN: 0740-3194, DOI: 10.1002/mrm.27947 * page 3 - page 12 * ----- | | |

TECHNICAL FIELDS
SEARCHED (IPC)

The present search report has been drawn up for all claims

| Place of search | Date of completion of the search | Examiner |
|---|---|---|
| Munich | 4 November 2019 | Durst, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 17 1216

This annex lists the patent family members relating to the patent documents cited in the above-mentioned European search report.
The members are as contained in the European Patent Office EDP file on
The European Patent Office is in no way liable for these particulars which are merely given for the purpose of information.

04-11-2019

| Patent document cited in search report | Publication date | Patent family member(s) | Publication date |
|---|---|---|---|
| WO 2018178343 A1 | 04-10-2018 | EP 3382415 A1<br>WO 2018178343 A1 | 03-10-2018<br>04-10-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **WHITTALL KP ; MACKAY AL.** Quantitative Interpretation of NMR Relaxation Data. *Journal of Magnetic Resonance,* 1969, vol. 84 (1), 134-152
- **KIM D ; WISNOWSKI JL ; NGUYEN CT ; HALDAR JP.** Relaxation-Relaxation Correlation Spectroscopic Imaging (RR-CSI): Leveraging the Blessings of Dimensionality to Map In Vivo Microstructure. *arXiv:180605752 [eess,* June 2018
- **LAWSON CL ; HANSON RJ.** Solving Least Squares Problems. SIAM. 1974
- **DUARTE MF ; SARVOTHAM S ; BARON D ; WAKIN MB ; BARANIUK RG.** Distributed Compressed Sensing of Jointly Sparse Signals. *Proceedings of the 2005 Asilomar Conference on Signals, Systems, and Computers IEEE,* 2005, 1537-1541
- **COTTER SF ; RAO BD ; KJERSTI ENGAN ; KREUTZ-DELGADO K.** Sparse Solutions to Linear Inverse Problems with Multiple Measurement Vectors. *IEEE Transactions on Signal Processing,* July 2005, vol. 53 (7), 2477-2488
- **TROPP JA ; GILBERT AC ; STRAUSS MJ.** Algorithms for Simultaneous Sparse Approximation. Part I: Greedy Pursuit. *Signal Processing,* March 2006, vol. 86 (3), 572-588
- **TROPP JA.** Algorithms for Simultaneous Sparse Approximation. Part II: Convex Relaxation. *Signal Processing,* March 2006, vol. 86 (3), 589-602
- **BLANCHARD JD ; CERMAK M ; HANLE D ; JING Y.** Greedy Algorithms for Joint Sparse Recovery. *IEEE Transactions on Signal Processing,* April 2014, vol. 62 (7), 1694-1704
- **JIANG Y ; MA D ; SEIBERLICH N ; GULANI V ; GRISWOLD MA.** MR Fingerprinting Using Fast Imaging with Steady State Precession (FISP) with Spiral Readout: MRFingerprinting with FISP. *Magnetic Resonance in Medicine,* December 2015, vol. 74 (6), 1621-1631